# EUROPEAN PATENT SPECIFICATION

(11) **EP 2 244 952 B1**
(45) Date of publication and mention of the grant of the patent: **16.10.2013**
(21) Application number: 08714825.0
(22) Date of filing: 19.02.2008
(51) Int. Cl.: B65D 6/02, B65D 6/24, H05K 5/04, H05K 7/20

(54) **ELECTRONIC CONTROL DEVICE AND ITS CASING**
ELEKTRONISCHE STEUERVORRICHTUNG UND GEHÄUSE DAFÜR
DISPOSITIF ÉLECTRONIQUE DE COMMANDE ET SON BOÎTIER

(43) Date of publication of application: 03.11.2010
(73) Proprietor: Bosch Automotive Products (Suzhou) Co., Ltd., Jiangsu 215021 (CN)
(72) Inventor: LI, Chencong, Jiangsu 215021 (CN); WICHARTZ, Georg, 71701 Schwieberdingen (DE); GRAEBER, Paul, 71634 Ludwigsburg (DE)
(74) Representative: Slickers, Dirk
(86) International application number: PCT/CN2008/000365
(87) International publication number: WO 2009/103184

(56) References cited:
- EP-A1- 0 628 487
- WO-A1-99/42374
- CN-Y- 2 211 961
- CN-Y- 2 211 961
- JP-A- 2004 039 750
- JP-A- 2004 039 750
- US-A- 1 909 136
- US-A- 1 909 136
- US-A- 2 741 390
- US-A- 3 950 603
- US-A- 3 950 603

## Description

### TECHNICAL FIELD

The present invention relates to a casing for an electronic control device, especially to a casing for a vehicle engine control device. The present invention also relates to an electronic control device provided with the casing.

### BACKGROUND ART

Nowadays, electronic control devices such as vehicle engine control devices usually have casings manufactured by pressure casting or press punching. The moulds or dies used in these processes are suffered from wearing or abbreviation and thus cannot have a long service life. For example, a pressure casting mould is generally used for only about 100,000 processing cycles. In addition, both processes are difficult to achieve flexible manufacture. Specifically, for a batch of control device casings of a particular size, a particular mould should be adopted. Thus, for manufacturing casings of various sizes, corresponding moulds should be used. No mould part is versatile to different casings. If the size of the casings is to be changed, corresponding mould should be prepared.

In summary, in the prior art, since the amount of the required moulds is large and the life time of each mould is short, the ratio of the capital for preparing the moulds, or the total mould cost, to the productivity is low. Meanwhile, the manufacture flexibility is also low.

US 3,950,603 shows an enclosure case of potless immobilization of circuit components with the two-piece enclosure case for securely immobilizing a wide variety of readily available modular circuit components. The enclosure case comprises two halves each of which has a top and a bottom respectively with two oppositely disposed side walls projecting therefrom.

JP 200439750 shows an electrical apparatus storage box which assures simplified manipulations for installing and removing a cover with upper and lower side plates and a real surface plate. A cover is structured of a front plate and right and left side plates for closing the opened front surface and right and left side surfaces of the body.

CN 2211961Y discloses a side wall profile material of containers.

US 1,909,136 relates to conduit boxes used for electrical house wiring, formed of a single piece of metal which is cast or punched out of sheet metal so that the bottom and the four sides comprise a single piece with the remaining side closed by a plate. The document shows a box constructed of two U-shaped pieces which are assembled together to form a box which has six sides and thereby completely enclosing the wires which are carried to the box and may be spliced therein with drop cords or extensions as desired.

### SUMMARY OF INVENTION

An object of the present invention is to provide a low cost casing for an electronic control device, wherein one or more of the components for forming the casing are versatile to different casings, and the casings can be manufactured in low cost.

To achieve this object, the present invention provides a casing for an electronic control device, especially for a control device of a vehicle engine. The casing comprises an upper cover and a lower cover. The upper cover and the lower cover each comprise an end wall and two side walls extended respectively from the opposite lateral ends of the end wall in the same perpendicular direction. The upper cover and the lower cover are assembled together facing each other in a complementary manner, so that a closed casing having a substantial rectangular parallelepiped shape is formed, wherein the end wall of the upper cover defines the top face of the rectangular parallelepiped, the end wall of the lower cover defines the bottom face of the rectangular parallelepiped, and the side walls of the upper cover and the lower cover define the four side faces of the rectangular parallelepiped. At least one of the upper cover and the lower cover is formed from a segment of profile material cut out from an extruded profile material.

Preferably, in an assembled state of the casing, the longitudinal direction of the upper cover and the longitudinal direction of the lower cover form an angle of 90° with each other.

Preferably, an electric board holding means is provided in the casing for holding the electric board inside the casing.

Preferably, the electric board holding means comprises supporting ribs integrally formed on the inner surfaces of the facing side walls of the lower cover in the longitudinal direction of the lower cover and supporting protrusions integrally formed at the corners between the side walls and the end wall of the upper cover and protruded downwardly from the end wall, with the lower surfaces of the supporting protrusions being separated from the upper surfaces of the supporting ribs by a vertical distance suitable for accommodating the thickness of the edges of the electric board.

Preferably, the supporting protrusions are integrally formed on the upper cover and extend along the longitudinal direction of the upper cover.

Preferably, the supporting protrusions are formed separately and then assembled onto the upper cover.

Preferably, the supporting protrusions are formed from a material having a heat conductivity higher than that of the upper cover.

Preferably, the supporting ribs are integrally formed on the lower cover and extend along the longitudinal direction of the lower cover, or are formed separately and then assembled onto the lower cover. Preferably, the casing further comprises one or more heat sinks which are integrally formed on the upper cover and/or the lower cover, or are formed separately and then assembled onto the upper cover and/or the lower cover.

Preferably, the casing further comprises a casing attaching means for positioning and mounting the casing to an outer structure.

Preferably, the casing attaching means comprises attaching ribs extending outwardly from the side walls of the upper cover and having one or more positioning holes therethrough.

Preferably, elastic shims are attached between the upper surfaces of the supporting ribs and the electric board and/or between the lower surfaces of the supporting protrusions and the electric board.

Preferably, a heat conducting adhesive paste is applied between the upper surfaces of the supporting ribs and the electric board and/or between the lower surfaces of the supporting protrusions and the electric board.

Preferably, the upper cover and/or the lower cover is provided with one or more insertion holes therethrough for inserting one or more plug members which connect the electric board with the outside.

Preferably, the abutting and/or neighbouring portions between the upper cover and the lower cover are provided with sealing members and/or a sealant.

Preferably, the casing further comprises a cover locking means for locking the upper cover and the lower cover into an assembled state.

Preferably, the cover locking means comprises hook portions which extend inwardly from the lower ends of the side walls of the upper cover for catching the lower surface of the end wall of the lower cover.

Preferably, the profile material is heat conductive and/or electric conductive.

Preferably, the profile material comprises an extruded metal.

Preferably, the profile material comprises extruded aluminum or aluminum alloy.

Preferably, the longitudinal length of the upper cover equals to the lateral width between the inner surfaces of the side walls of the lower cover, and the longitudinal length of the lower cover equals to the lateral width between the inner surfaces of the side walls of the upper cover.

The present invention also provides an electronic control device which comprises the casing described above and an electric board held in the casing.

The electronic control device is preferably a control device for a vehicle engine.

### BRIEF DESCRIPTION OF THE DRAWINGS

The preferred embodiments of the present invention will be described in details with reference to the drawings, wherein:
Fig. 1 is a front sectional view of a preferred embodiment of the electronic control device of the present invention;
Fig. 2 is a side sectional view of a preferred embodiment of the electronic control device of the present invention;
Fig. 3 is a cross sectional view of a preferred embodiment of the upper cover of the electronic control device of the present invention;
Fig. 4 is a cross sectional view of a preferred embodiment of the lower cover of the electronic control device of the present invention;
Fig. 5 is a schematic view of a preferred embodiment of the profile material for forming the upper cover of the present invention; and
Fig. 6 is a schematic view of a preferred embodiment of the profile material for forming the lower cover of the present invention.

### DETAILED DESCRIPTION TO THE EMBODIMENTS

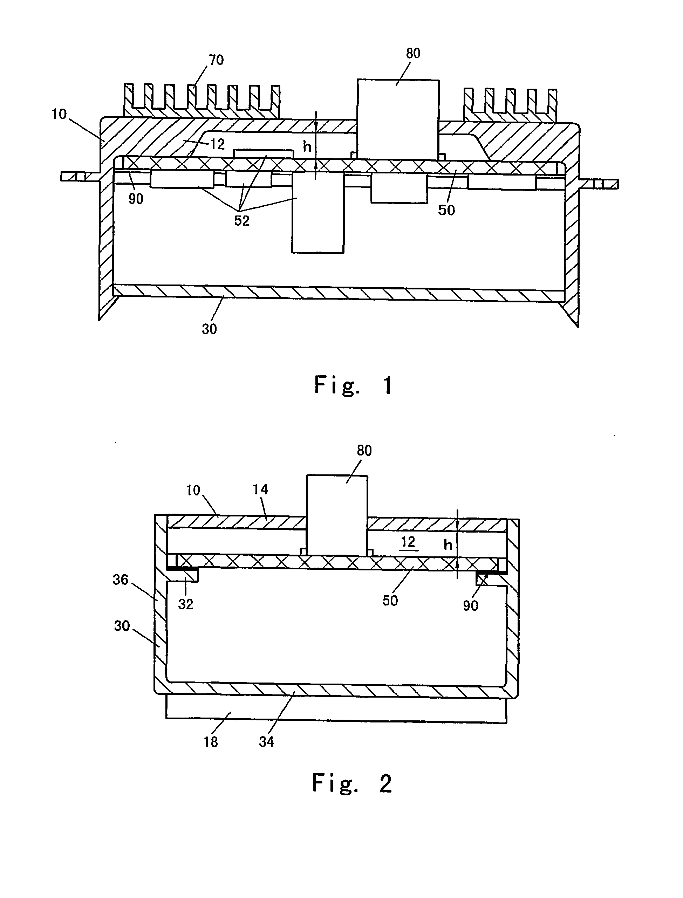

Figs. 1 and 2 show a preferred embodiment of the electronic control device of the present invention from different directions.

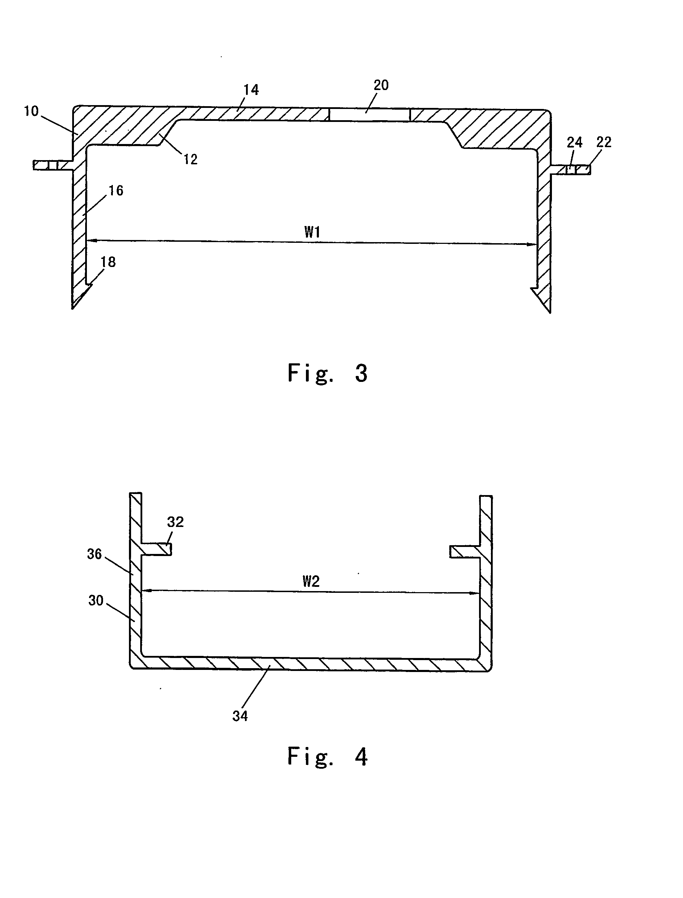

The electronic control device of the present invention comprises a casing and an electric board 50 held in the casing. The casing comprises an upper cover 10 and a lower cover 30. As shown in Fig. 3, the upper cover 10 comprises an end wall 14 and two side walls 16 extended respectively from the opposite lateral ends of the end wall 14 in the same perpendicular direction. As shown in Fig. 4, the lower cover 30 comprises an end wall 34 and two side walls 36 extended from the opposite lateral ends of the end wall 34 in the same perpendicular direction. In this way, each of the upper cover and the lower cover has a U-shaped or slot-shaped cross-section.

The upper cover 10 and the lower cover 30 are assembled together facing each other in a complementary manner, so that a closed casing having a substantial rectangular parallelepiped shape is formed, wherein the end wall 14 of the upper cover 10 defines the top face of the rectangular parallelepiped, the end wall 34 of the lower cover 30 defines the bottom face of the rectangular parallelepiped, and the side walls 16 and 36 of the upper cover 10 and the lower cover 30 define the four side faces of the rectangular parallelepiped. The casing encircles an inner space for arranging an electric board 50. The electric board 50 is provided with electronic components 52, as shown in Fig. 1. For purpose of clarity, these electronic components 52 are not shown in Fig. 2.

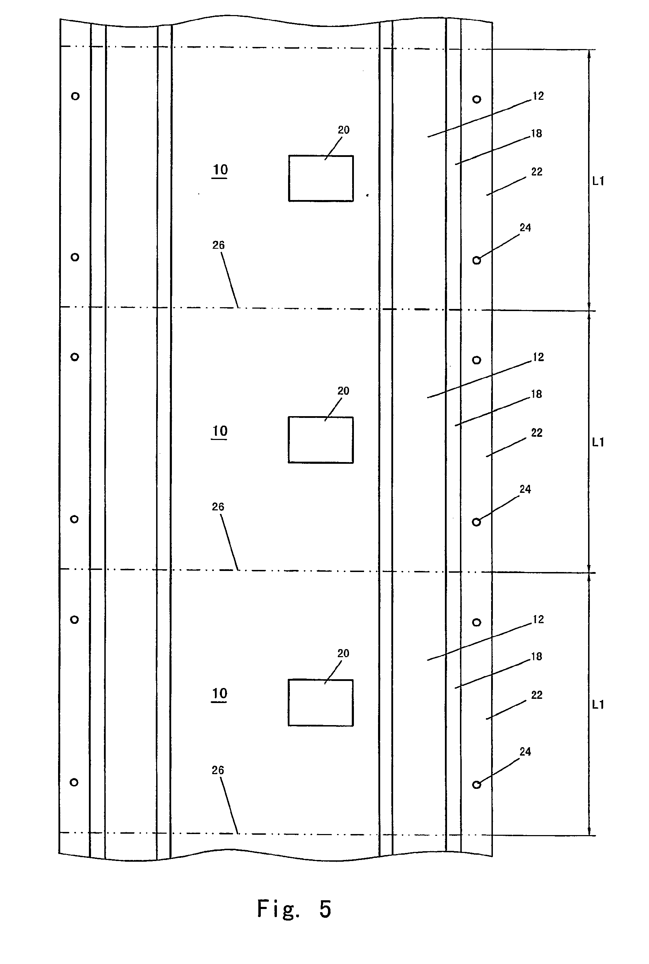

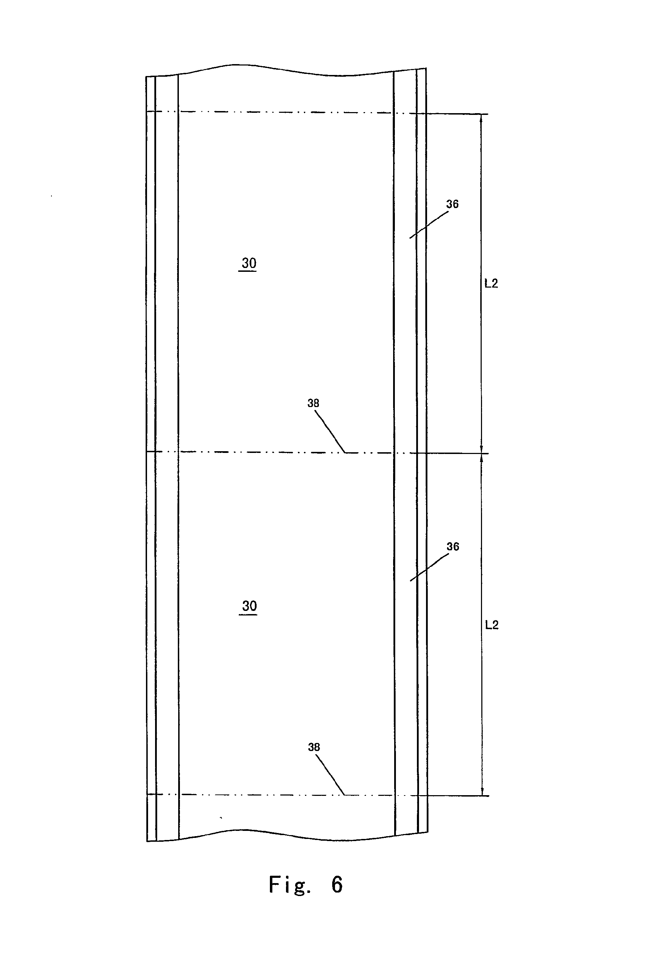

As shown in Figs. 5 and 6, the upper cover 10 and the lower cover 30 each can be obtained by cutting a corresponding profile material which is formed by metal extrusion. Each of the upper cover 10 and the lower cover 30 has a longitudinal direction defined as the extension direction of the profile material, i.e., the direction perpendicular to the paper of Figs. 3 and 4. Moreover, each of the upper cover 10 and the lower cover 30 has a lateral direction defined as its widthwise direction, i.e., the left-right direction in Figs. 3 and 4. In the assembled state of the casing, the longitudinal direction of the upper cover crosses with the longitudinal direction of the lower cover, with an angle of 90° formed therebetween, the end wall 14 of the upper cover 10 fits between the distal ends of the side walls 36 of the lower cover 30, and the end wall 34 of the lower cover 30 fits between the distal ends of the side walls 16 of the upper cover 10. Meanwhile, in order to form a substantial seal between the upper cover and the lower cover, the longitudinal length L1 of the upper cover 10 equals to the lateral width W2 between the inner surfaces of the side walls 36 of the lower cover 30, and the longitudinal length L2 of the lower cover 30 equals to the lateral width W1 between the inner surfaces of the side walls 16 of the upper cover 10. Here the term "equals to" should be interpreted as including tolerances necessary for assembling.

To achieve the power supply and the communication of the electric board 50, a plug member 80 is used for connecting the electric board 50 with the outside. To this end, an insertion hole 20 is formed through the casing for inserting the plug member 80. In the illustrated embodiments, the insertion hole 20 is formed in the end wall 14 of the upper cover 10. However, the insertion hole 20 may be formed in the end wall 34 of the lower cover 30, or formed in other portions of the upper cover 10 or the lower cover 30. Alternatively, a plurality of insertion holes may be formed.

To achieve the positioning of the electric board 50 inside the casing, an electric board holding means or structure may be provided in the casing. As an optional design, the electric board holding means comprises supporting ribs 32 integrally formed on the inner surfaces of the facing side walls 36 of the lower cover 30 in the longitudinal direction and supporting protrusions 12 integrally formed at the corners between the side walls 16 and the end wall 14 of the upper cover 10 and protruded downwardly from the end wall 14. As shown in Figs. 1 and 2, the electric board 50 is clamped between the supporting ribs 32 and the supporting protrusions 12 under compressive forces, wherein the supporting ribs 32 support the opposite parallel lower edges of the electric board 50 from under side, while the supporting protrusions 12 urges the opposite parallel upper edges of the electric board from upper side. The upper edges form an angle of 90° with the lower edges.

In the illustrated embodiments, each of the supporting ribs 32 takes a cross-section shape of a flat panel. However, other cross-section shapes are also possible, for example, triangular, rectangular, trapezoidal, etc., so long as it can provide a horizontal upper supporting surface.

In the illustrated embodiments, each of the supporting protrusions 12 is a solid thickening portion. However, other forms are also possible, so long as it can provide a horizontal lower supporting surface.

Preferably, the supporting protrusions 12 and the supporting ribs 32 are integrally formed on the upper cover 10 and the lower cover 30 respectively. However, it is also possible to form the supporting protrusions 12 and/or the supporting ribs 32 separately and then mount them to the upper cover 10 and/or the lower cover 30. In this case, the material and/or characteristics of the supporting protrusions 12 and/or the supporting ribs 32 may be different from that of the upper cover 10 and/or the lower cover 30, and thus the flexibility of design and manufacture can be increased.

To improve the heat dissipation ability of the whole electronic control device, one or more heat sinks 70 may be provided onto the upper cover and/or the lower cover. In the embodiment shown in Fig. 1, two fin-type heat sinks 70 are provided to the end wall 14 of the upper cover 10. It can be understood that there is no restriction to the form of the heat sinks, and heat sinks of other forms may also be used. For example, a cooling fan may be provided additionally or alternatively. Further, there is no restriction to the number of the heat sinks. For example, a plurality of heat sinks may be provided to the upper cover 10 and the lower cover 30. The position of the heat sink(s) should be selected in favor of the heat dissipation of the electric board. Advantageously, the heat sink(s) is(are) proximate to the supporting protrusions 12 of the upper cover 10. In the case that the supporting protrusions 12 are separately formed, it is preferred that the material of the supporting protrusions 12 has a higher heat conductivity than that of the upper cover.

By means of the supporting protrusions 12, a vertical distance "h" is formed between the lower surface of the end wall 14 of the upper cover 10 and the upper surface of the electric board 50. This distance corresponds to the protruding height of the supporting protrusions 12 from the lower surface of the end wall 14 and provides an arranging space for the electronic components on the upper surface of the electric board. The protruding height of the supporting protrusions 12 may be selected according to concrete requirements. The supporting protrusions 12 also function to conduct the heat inside the casing and the electric board to the outside.

In the assembled state of the casing, the lower surfaces of the supporting protrusions 12 are separated from the upper surfaces of the supporting ribs 32 by a vertical distance suitable for accommodating the thickness of the edges of the electric board.

The heat sink(s) 70 may be formed integrally on the upper cover and/or the lower cover, for example, simultaneously formed with the upper cover and/or the lower cover during the extrusion process so as to lowering the manufacture cost. Alternatively, the heat sink(s) 70 may be formed separately and then mounted to (for example, by adhesive) the upper cover and/or the lower cover so as to improve the manufacture flexibility.

In order to prevent the electric board from misplacement with respect to the casing, an electric board restraining means or structure may be provided in the casing. For example, alignment slots, alignment projections or the like may be formed on the supporting protrusions 12 and the supporting ribs 32. Alternatively, the electric board may be adhered to the supporting protrusions 12 and/or the supporting ribs 32. For example, the electric board may be adhered to the supporting protrusions 12 and/or the supporting ribs 32 by a heat conducting adhesive paste.

Moreover, to compensate the manufacture error of the distance between the supporting protrusions 12 and the supporting ribs 32, elastic shims 90 may be provided between the upper surfaces of the supporting ribs 32 and the lower surface of the electric board and/or between the lower surfaces of the supporting protrusions 12 and the upper surface of the electric board. In this way, the elastic shims also provide a shock damping function to the electric board as well as prevent the electric board from being crushed by the supporting protrusions 12 and the supporting ribs 32.

To lock the casing in the assembled state, the upper cover 10 and the lower cover 30 are provided with a cover locking means or structure. For example, in the illustrated embodiments, the lower ends of the side walls 16 of the upper cover 10 are formed with hook portions 18 which extend inwardly, for catching the lower surface of the end wall 34 of the lower cover 30, so as to lock the upper cover 10 and the lower cover 30 in the assembled state. It can be understood that the cover locking means may instead be formed on the lower cover 30, or formed on both of the upper cover 10 and the lower cover 30. The cover locking means may be formed integrally with other portions of the upper cover and/or the lower cover, or instead be formed separately. The cover locking means may adopt other forms such as screws, locking pins, a ball-socket mating structure, a snap lock structure, and the like.

To achieve the positioning and mounting of the electronic control device and the casing to an outer structure, a casing attaching means or structure may be provided on the casing. In the illustrated embodiments, the casing attaching means comprises attaching ribs 22 extending outwardly from the side walls 16 of the upper cover 10, each attaching rib being formed with one or more positioning holes 24 therethrough. It can be understood that the casing attaching means may adopt other forms. For example, it may have a locking structure such as hook or slot, or may be formed only by holes through the wall of the upper cover or the lower cover. The casing attaching means may be formed at any suitable positions on the upper cover and/or the lower cover, and may either be formed integrally on the upper cover and/or the lower cover or be formed separately.

In order to improve the seal between the upper cover and the lower cover, sealing members and/or a sealant may be provided at the abutting and/or neighbouring portions of the upper cover and the lower cover.

The seal is provided mainly for preventing foreign objects from entering into the casing, so at to be, for example, waterproof, and to prevent the electronic components from being invaded by other material (such as engine oil, battery liquid, drained rain water, and the like).

The seal may include prefabricated sealing members, or may include a sealant applied when assembling, or may even include an injected sealant for protecting the electronic components.

The selection of the seal depends on the application environment of the control device. In the case that the control device is used in a condition of not directly contacting with water or other material, structures without any seal are also possible.

As mentioned above, each of the upper cover 10 and the lower cover 30 comprises a segment of profile material formed by metal extrusion. Metals suitable for forming the upper cover and the lower cover include highly plastic metal materials such as aluminum, copper, low carbon steel, low alloy steel and the like. The upper cover and/or the lower cover should have heat conductivity which is enough to remove the heat from the casing and the electric board. In order to electrically and magnetically shield the inner space of the casing, the upper cover and/or the lower cover is preferably electric conductive. Taking all these factors into consideration, aluminum and aluminum alloy are more suitable for forming the upper cover and the lower cover. Aluminum and aluminum alloy have an additional advantage of being light weighted. The upper cover and the lower cover may be formed with the same or different materials.

By means of extrusion, continuous profile materials shown in Figs. 5 and 6 are produced, each of which has a cross-section shape (U-shape or slot-shape) required by the upper cover 10 and the lower cover 30. Each of the continuous profile materials is laterally cut along cutting lines 26 or 36 separated from each other by a longitudinal length L1 or L2 into segments of profile material, thus forming a plurality of upper covers 10 or lower covers 30.

Comparing with pressure casting and press punching, extrusion process can obtain the advantages of lowering the wear of the moulds and reducing the material waste during the process. Thus, the manufacture cost can be reduced.

In addition, for a batch of a certain type of cover (the upper cover or the lower cover), the lateral width of its profile material is constant, and the longitudinal length to be cut is changeable, so as to be fit with mating covers of different lateral widths. For example, upper covers of different sizes may be formed from the same profile material by cutting, such that the upper covers may have the same lateral width and different longitudinal lengths, so as to be fit with lower covers having the same longitudinal length and different lateral widths, and vice versa. In this way, a serious of casings of different sizes can be provided, wherein upper or lower covers of different lengths may be cut out from the same profile material. As a result, the manufacture flexibility can be improved.

In Fig. 5, the profile material is shown as having been formed with the insertion holes 20 and the positioning holes 24. It can be understood that the number and the locations of the insertion holes 20 and the positioning holes 24 are not restricted to what are shown. Meanwhile, the insertion holes 20 and the positioning holes 24 may either be formed before the profile material is cut along cutting lines 26 or be formed after the profile material is cut. The insertion holes 20 and the positioning holes 24 can be formed by known machining processes such as punching, drilling, milling, wire cutting, spark discharging and the like.

The case that the upper cover 10 and the lower cover 30 are both formed from segments of profile material is discussed above. Alternatively, one of the upper cover 10 and the lower cover 30 may be formed from a segment of profile material, while the other is formed in other ways (for example, by traditional pressure casting or press punching). Even in this case, since one of a pair of covers is formed from a segment of profile material, the advantages of lowering manufacture cost and improving manufacture flexibility can be obtained, although in a less extend.

In the embodiments described above, each of the upper cover 10 and the lower cover 30 has a single-piece structure. However, one or both of them may have a multi-piece structure, or be formed by assembling two or more parts.

The electronic control device of the present invention may be a vehicle engine control device which is applicable in various motor vehicles. However, the application of the electronic control device of the present invention and its casing is not restricted to this, and their applications in other fields also fall into the scope of the present invention.

## Claims

1. A casing for an electronic control device, the casing comprising an upper cover (10) and a lower cove (30), the upper cover and the lower cover each comprising an end wall (14,34) and two side walls (16,36) extended respectively from the opposite lateral ends of the end wall in the same perpendicular direction, the upper cover and the lower cover being assembled together facing each other in a complementary manner, so that a closed casing having a generally rectangular shape is formed, wherein the end wall (14) of the upper cover defines the top face of the rectangular parallelepiped, the end wall (34) of the lower cover defines the bottom face of the rectangular parallelepiped, and the side walls (16,36) of the upper cover and the lower cover define the four side faces of the rectangular parallelepiped, and wherein at least one of the upper cover (10) and the lower (30) cover is formed from a segment of profile material cut out from an extruded profile material.

2. The casing of claim 1, wherein, in an assembled state of the casing, the longitudinal direction of the upper cover (10) and the longitudinal direction of the lower cover (30) form an angle of 90° with each other.

3. The casing of claim 1, wherein an electric board holding means (32) is provided in the casing for holding the electric board inside the casing.

4. The casing of claim 3, wherein the electric board holding means comprises supporting ribs (32) integrally formed on the inner surfaces of the facing side walls (36) of the lower cover in the longitudinal direction of the lower cover and supporting protrusions (12) integrally formed at the corners between the side walls (16) and the end wall (14) of the upper cover and protruded downwardly from the end wall, with the lower surfaces of the supporting protrusions being separated from the upper surfaces of the supporting ribs by a vertical distance suitable for accommodating the thickness of the edges of the electric board.

5. The casing of claim 4, wherein the supporting protrusions (12) are integrally formed on the upper cover and extend along the longitudinal direction of the upper cover.

6. The casing of claim 4, wherein the supporting protrusions (12) are formed separately and then assembled onto the upper cover.

7. The casing of claim 6, wherein the supporting protrusions (12) are formed from a material having a heat conductivity higher than that of the upper cover.

8. The casing of claim 4, wherein the supporting ribs (32) are integrally formed on the lower cover and extend along the longitudinal direction of the lower cover, or are formed separately and then assembled onto the lower cover.

9. The casing of claim 1, further comprising one or more heat sinks (70) which are integrally formed on the upper cover and/or the lower cover, or are formed separately and then assembled onto the upper cover and/or the lower cover.

10. The casing of claim 1, further comprising a casing attaching means (22) for positioning and mounting the casing to an outer structure.

11. The casing of claim 10, wherein the casing attaching means (22) comprises attaching ribs (22) extending outwardly from the side walls of the upper cover and having one or more positioning holes therethrough.

12. The casing of claim 4, wherein elastic shims (90) are attached between the upper surfaces of the supporting ribs and the electric board and/or between the lower surfaces of the supporting protrusions and the electric board.

13. The casing of claim 4, wherein a heat conducting adhesive paste is applied between the upper surfaces of the supporting ribs (32) and the electric board (50) and/or between the lower surfaces of the supporting protrusions (12) and the electric board (50).

14. The casing of claim 3, wherein the upper cover (10) and/or the lower cover (30) is provided with one or more insertion holes (20) therethrough for inserting one or more plug members (80) which connect the electric board with the outside.

15. The casing of claim 1, wherein the abutting and/or neighbouring portions between the upper cover and the lower cover are provided with sealing members and/or a sealant.

16. The casing of claim 1, further comprising a cover locking means for locking the upper cover and the lower cover into an assembled state.

17. The casing of claim 16, wherein the cover locking means comprises hook portions (18) which extend inwardly from the lower ends of the side walls of the upper cover for catching the lower surface of the end wall of the lower cover.

18. The casing of one of claims 1 to 17, wherein the profile material is heat conductive and/or electric conductive.

19. The casing of claim 18, wherein the profile material comprises an extruded metal.

20. The casing of claim 19, wherein the profile material comprises extruded aluminum or aluminum alloy.

21. The casing of one of claims 1 to 17, wherein the longitudinal length of the upper cover (10) equals to the lateral width between the inner surfaces of the side walls of the lower cover (30), and the longitudinal length of the lower cover (30) equals to the lateral width between the inner surfaces of the side walls of the upper cover (10).

22. An electronic control device comprising a casing of one of claims 1 to 21 and an electric board held in the casing.

23. The electronic control device of claim 22, comprising a control device for a vehicle engine.

## Patentansprüche

1. Gehäuse für eine elektronische Steuervorrichtung, wobei das Gehäuse eine obere Abdeckung (10) und eine untere Abdeckung (30) umfasst, wobei die obere Abdeckung und die untere Abdeckung jeweils eine Endwand (14, 34) und zwei Seitenwände (16, 36) umfassen, die sich jeweils von den gegenüberliegenden lateralen Enden der Endwand in der gleichen senkrechten Richtung erstrecken, wobei die obere Abdeckung und die untere Abdeckung so aneinander montiert sind, dass sie komplementär zueinander weisen, so dass ein geschlossenes Gehäuse mit einer allgemein rechteckigen Form gebildet wird, wobei die Endwand (14) der oberen Abdeckung die Oberseite des rechteckigen Parallelepipeds definiert, die Endwand (34) der unteren Abdeckung die Unterseite des rechteckigen Parallelepipeds definiert und die Seitenwände (16, 36) der oberen Abdeckung und der unteren Abdeckung vier laterale Seiten des rechteckigen Parallelepipeds definieren und wobei die obere Abdeckung (10) und/oder die untere Abdeckung (30) aus einem Segment eines aus einem extrudierten Profilmaterial ausgeschnittenen Profilmaterials hergestellt ist/sind.

2. Gehäuse nach Anspruch 1, wobei die Längsrichtung der oberen Abdeckung (10) und die Längsrichtung der unteren Abdeckung (30) im montierten Zustand des Gehäuses einen Winkel von 90° miteinander bilden.

3. Gehäuse nach Anspruch 1, wobei in dem Gehäuse ein Haltemittel (32) für eine elektrische Platine zum Halten der elektrischen Platine in dem Gehäuse vorgesehen ist.

4. Gehäuse nach Anspruch 3, wobei das Haltemittel für eine elektrische Platine Stützrippen (32), die an den Innenflächen der zueinander weisenden Seitenwände (36) der unteren Abdeckung in der Längsrichtung der unteren Abdeckung integral ausgebildet sind, und Stützvorsprünge (12), die an den Ecken zwischen den Seitenwänden (16) und der Endwand (14) der oberen Abdeckung integral ausgebildet sind und von der Endwand nach unten vorstehen, umfasst, wobei die unteren Flächen der Stützvorsprünge von den oberen Flächen der Stützrippen durch einen vertikalen Abstand, der dazu geeignet ist, die Dicke der Ränder der elektrischen Platine aufzunehmen, getrennt sind.

5. Gehäuse nach Anspruch 4, wobei die Stützvorsprünge (12) an der oberen Abdeckung integral ausgebildet sind und sich entlang der Längsrichtung der oberen Abdeckung erstrecken.

6. Gehäuse nach Anspruch 4, wobei die Stützvorsprünge (12) getrennt ausgebildet und dann an der oberen Abdeckung montiert sind.

7. Gehäuse nach Anspruch 6, wobei die Stützvorsprünge (12) aus einem Material hergestellt sind, das eine Wärmeleitfähigkeit aufweist, die höher ist als die der oberen Abdeckung.

8. Gehäuse nach Anspruch 4, wobei die Stützrippen (32) an der unteren Abdeckung integral ausgebildet sind und sich entlang der Längsrichtung der unteren Abdeckung erstrecken, oder getrennt ausgebildet und dann an der unteren Abdeckung montiert sind.

9. Gehäuse nach Anspruch 1, das ferner einen oder mehrere Kühlkörper (70) umfasst, die an der oberen Abdeckung und/oder der unteren Abdeckung integral ausgebildet sind oder getrennt ausgebildet und dann an der oberen Abdeckung und/oder der unteren Abdeckung montiert sind.

10. Gehäuse nach Anspruch 1, das ferner ein Gehäusebefestigungsmittel (22) zum Positionieren und Anbringen des Gehäuses an einer äußeren Struktur umfasst.

11. Gehäuse nach Anspruch 10, wobei das Gehäusebefestigungsmittel (22) Befestigungsrippen (22) umfasst, die sich von den Seitenwänden der oberen Abdeckung nach außen erstrecken und ein oder mehrere Positionierungslöcher durch sie hindurch aufweisen.

12. Gehäuse nach Anspruch 4, wobei elastische Unterlagen (90) zwischen den oberen Flächen der Stützrippen und der elektrischen Platine und/oder zwischen den unteren Flächen der Stützvorsprünge und der elektrischen Platine befestigt sind.

13. Gehäuse nach Anspruch 4, wobei eine wärmeleitende Klebepaste zwischen den oberen Flächen der Stützrippen (32) und der elektrischen Platine (50) und/oder zwischen den unteren Flächen der Stützvorsprünge (12) und der elektrischen Platine (50) aufgebracht ist.

14. Gehäuse nach Anspruch 3, wobei die obere Abdeckung (10) und/oder die untere Abdeckung (30) mit einem oder mehreren Einführlöchern (20) durch sie hindurch zum Einführen eines oder mehrerer Steckerelemente (80), die die elektrische Platine nach außen verbinden, versehen ist/sind.

15. Gehäuse nach Anspruch 1, wobei die anliegenden und/oder benachbarten Abschnitte zwischen der oberen Abdeckung und der unteren Abdeckung mit Abdichtelementen und/oder einem Abdichtmittel versehen sind.

16. Gehäuse nach Anspruch 1, das ferner ein Abdeckungsverriegelungsmittel zum Verriegeln der oberen Abdeckung und der unteren Abdeckung in einen montierten Zustand umfasst.

17. Gehäuse nach Anspruch 16, wobei das Abdeckungsverriegelungsmittel Hakenabschnitte (18) umfasst, die sich zum Erfassen der unteren Fläche der Endwand der unteren Abdeckung von den unteren Enden der Seitenwände der oberen Abdeckung nach innen erstrecken.

18. Gehäuse nach einem der Ansprüche 1 bis 17, wobei das Profilmaterial wärmeleitfähig und/oder elektrisch leitfähig ist.

19. Gehäuse nach Anspruch 18, wobei das Profilmaterial ein extrudiertes Metall umfasst.

20. Gehäuse nach Anspruch 19, wobei das Profilmaterial extrudiertes Aluminium oder eine extrudierte Aluminiumlegierung umfasst.

21. Gehäuse nach einem der Ansprüche 1 bis 17, wobei die longitudinale Länge der oberen Abdeckung (10) der lateralen Breite zwischen den Innenflächen der Seitenwände der unteren Abdeckung (30) entspricht und die longitudinale Länge der unteren Abdeckung (30) der lateralen Breite zwischen den Innenflächen der Seitenwände der oberen Abdeckung (10) entspricht.

22. Elektronische Steuervorrichtung, die ein Gehäuse nach einem der Ansprüche 1 bis 21 und eine in dem Gehäuse gehaltene elektrische Platine umfasst.

23. Elektronische Steuervorrichtung nach Anspruch 22, die eine Steuervorrichtung für einen Fahrzeugmotor umfasst.

## Revendications

1. Boîtier pour un dispositif électronique de commande, le boîtier comprenant un couvercle supérieur (10) et un couvercle inférieur (30), le couvercle supérieur et le couvercle inférieur comprenant chacun une paroi d'extrémité (14, 34) et deux parois latérales (16, 36) s'étendant respectivement à partir des extrémités latérales opposées de la paroi d'extrémité dans la même direction perpendiculaire, le couvercle supérieur et le couvercle inférieur étant assemblés l'un à l'autre en regard l'un de l'autre de manière complémentaire, de telle sorte qu'un boîtier fermé présentant une forme générale rectangulaire soit formé, la paroi d'extrémité (14) du couvercle supérieur définissant la face supérieure du parallélépipède rectangle, la paroi d'extrémité (34) du couvercle inférieur définissant la face inférieure du parallélépipède rectangle, et les parois latérales (16, 36) du couvercle supérieur et du couvercle inférieur définissant les quatre faces latérales du parallélépipède rectangle, et au moins l'un du couvercle supérieur (10) et du couvercle inférieur (30) étant formé à partir d'un segment de matériau profilé découpé dans un matériau profilé extrudé.

2. Boîtier selon la revendication 1, dans lequel, dans un état assemblé du boîtier, la direction longitudinale du couvercle supérieur (10) et la direction longitudinale du couvercle inférieur (30) forment conjointement un angle de 90°.

3. Boîtier selon la revendication 1, un moyen de support de carte électrique (32) étant prévu dans le boîtier pour maintenir la carte électrique à l'intérieur du boîtier.

4. Boîtier selon la revendication 3, le moyen de support de carte électrique comprenant des nervures de support (32) formées d'un seul tenant sur les surfaces internes des parois latérales en regard (36) du couvercle inférieur dans la direction longitudinale du couvercle inférieur et des protubérances de support (12) formées d'un seul tenant au niveau des coins entre les parois latérales (16) et la paroi d'extrémité (14) du couvercle supérieur et faisant saillie vers le bas à partir de la paroi d'extrémité, les surfaces inférieures des protubérances de support étant séparées des surfaces supérieures des nervures de support par une distance verticale appropriée pour accueillir l'épaisseur des bords de la carte électrique.

5. Boîtier selon la revendication 4, les protubérances de support (12) étant formées d'un seul tenant sur le couvercle supérieur et s'étendant le long de la direction longitudinale du couvercle supérieur.

6. Boîtier selon la revendication 4, les protubérances de support (12) étant formées séparément puis assemblées sur le couvercle supérieur.

7. Boîtier selon la revendication 6, les protubérances de support (12) étant constituées d'un matériau présentant une conductivité thermique supérieure à celle du couvercle supérieur.

8. Boîtier selon la revendication 4, les nervures de support (32) étant formées d'un seul tenant sur le couvercle inférieur et s'étendant le long de la direction longitudinale du couvercle inférieur, ou étant formées séparément puis assemblées sur le couvercle inférieur.

9. Boîtier selon la revendication 1, comprenant en outre un ou plusieurs dissipateurs de chaleur (70) qui sont formés d'un seul tenant sur le couvercle supérieur et/ou le couvercle inférieur, ou qui sont formés séparément puis assemblés sur le couvercle supérieur et/ou le couvercle inférieur.

10. Boîtier selon la revendication 1, comprenant en outre un moyen de fixation de boîtier (22) pour positionner et monter le boîtier sur une structure externe.

11. Boîtier selon la revendication 10, le moyen de fixation de boîtier (22) comprenant des nervures de fixation (22) qui s'étendent vers l'extérieur à partir des parois latérales du couvercle supérieur et qui comportent un ou plusieurs orifices de positionnement les traversant.

12. Boîtier selon la revendication 4, des cales élastiques (90) étant fixées entre les surfaces supérieures des nervures de support et la carte électronique et/ou entre les surfaces inférieures des protubérances de support et la carte électronique.

13. Boîtier selon la revendication 4, une pâte adhésive thermoconductrice étant appliquée entre les surfaces supérieures des nervures de support (32) et la carte électrique (50) et/ou entre les surfaces inférieures des protubérances de support (12) et la carte électrique (50).

14. Boîtier selon la revendication 3, le couvercle supérieur (10) et/ou le couvercle inférieur (30) étant dotés d'un ou plusieurs orifices d'insertion (20) les traversant en vue de l'insertion d'un ou plusieurs éléments formant fiches (80) qui connectent la carte électrique à l'extérieur.

15. Boîtier selon la revendication 1, les parties accolées et/ou adjacentes entre le couvercle supérieur et le couvercle inférieur étant dotées d'éléments d'étanchéité et/ou d'un matériau d'étanchéité.

16. Boîtier selon la revendication 1, comprenant en outre un moyen de verrouillage de couvercles pour verrouiller le couvercle supérieur et le couvercle inférieur dans un état assemblé.

17. Boîtier selon la revendication 16, le moyen de verrouillage de couvercles comprenant des parties formant crochets (18) qui s'étendent vers l'intérieur à partir des extrémités inférieures des parois latérales du couvercle supérieur pour venir en prise avec la surface inférieure de la paroi d'extrémité du couvercle inférieur.

18. Boîtier selon l'une des revendications 1 à 17, le matériau profilé étant thermoconducteur et/ou électroconducteur.

19. Boîtier selon la revendication 18, le matériau profilé comprenant un métal extrudé.

20. Boîtier selon la revendication 19, le matériau profilé comprenant de l'aluminium ou un alliage d'aluminium extrudé.

21. Boîtier selon l'une des revendications 1 à 17, la longueur longitudinale du couvercle supérieur (10) étant égale à la largeur latérale entre les surfaces internes des parois latérales du couvercle inférieur (30), et la longueur longitudinale du couvercle inférieur (30) étant égale à la largeur latérale entre les surfaces internes des parois latérales du couvercle supérieur (10).

22. Dispositif électronique de commande comprenant un boîtier selon l'une des revendications 1 à 21 et une carte électrique maintenue dans le boîtier.

23. Dispositif électronique de commande selon la revendication 22, comprenant un dispositif de commande pour un moteur de véhicule.
